(19) Europäisches Patentamt
European Patent Office
Office européen des brevets

(11) **EP 4 614 665 A1**

(12) **EUROPEAN PATENT APPLICATION**

(43) Date of publication:
**10.09.2025 Bulletin 2025/37**

(21) Application number: 25162224.7

(22) Date of filing: **07.03.2025**

(51) International Patent Classification (IPC):
*H01M 10/42* (2006.01)  *H01M 50/581* (2021.01)
*H01H 85/00* (2006.01)  *H01H 85/06* (2006.01)
*H05K 1/00* (2006.01)  *H01M 50/519* (2021.01)
*H01H 85/02* (2006.01)  *H01H 85/38* (2006.01)

(52) Cooperative Patent Classification (CPC):
**H01M 50/581; H01H 85/0073; H01H 85/06;**
**H01M 10/425; H05K 1/00;** H01H 2085/025;
H01H 2085/383; H01M 50/519; H01M 2200/103

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **07.03.2024 KR 20240032580**

(71) Applicant: **SAMSUNG SDI CO., LTD.**
**Yongin-si, Gyeonggi-do 17084 (KR)**

(72) Inventor: **Park, Kyung Hoon**
**Suwon-si, Gyeonggi-do 16678 (KR)**

(74) Representative: **Gulde & Partner**
**Patent- und Rechtsanwaltskanzlei mbB**
**Berliner Freiheit 2**
**10785 Berlin (DE)**

(54) **PROTECTION CIRCUIT MODULE AND BATTERY MODULE COMPRISING THE SAME**

(57) Disclosed are a protection circuit module and a battery module capable of detecting a trigger cell in which heat propagation occurs within the battery module, even when heat propagation occurs in a battery cell that does not have a temperature sensor. The protection circuit module includes: a substrate; a wire disposed on the substrate to form an opening in at least a portion of the wire and the wire including a first metal; a solder including a second metal having a melting point lower than a melting point of the first metal and the second metal being inserted into at least a portion of the opening to join end of the wire separated by the opening; and a cover forming at least one hole and covering at least a portion of the solder.

FIG. 6

## Description

### FIELD

The technology described herein relates to a protection circuit module and/or a battery module including the same.

### BACKGROUND

A secondary battery can be charged and discharged unlike a primary cell that may not be repeatedly charged. Low-capacity secondary batteries are typically used in small, portable electronic devices, such as smartphones, feature phones, notebook computers, digital cameras, and camcorders, and high-capacity secondary batteries are widely used as power sources for motors in hybrid and electric vehicles and as power storage cells. Such a secondary battery includes an electrode assembly, a case receiving the electrode assembly, and electrode terminals connected to the electrode assembly.

This section is intended only to provide a better understanding of the background of the technology described herein and thus may include information which is not necessarily prior art.

### SUMMARY

The invention is defined by the appended claims. The description that follows is subjected to this limitation. Any disclosure lying outside the scope of said claims is only intended for illustrative as well as comparative purposes.

It is one aspect of the technology described herein to provide a protection circuit module and/or a battery module capable of detecting a trigger cell (cell from which heat propagates) having an increased temperature upon increase in temperature of each of a plurality of battery cells.

It is another aspect of the technology described herein to provide a protection circuit module and/or a battery module capable of detecting a trigger cell without applying a temperature sensor.

For example, the technology described herein enables detection of a trigger cell among battery cells without applying temperature sensors to all of the battery cells.

It is a further aspect of the technology described herein to provide a protection circuit module and/or a battery module capable of detecting a trigger cell while reducing manufacturing costs.

The above and other aspects and features of the technology described herein will become apparent from the following description of embodiments of the technology described herein.

In accordance with one aspect of the technology described herein, a protection circuit module includes: a substrate; a wire disposed on the substrate to form an opening in at least a portion of the wire and the wire including a first metal; a solder including a second metal having a melting point lower than a melting point of the first metal and the second metal being inserted into at least a portion of the opening to join ends of the wire separated by the opening; and a cover forming at least one hole and covering at least a portion of the solder.

In accordance with another aspect of the technology described herein, a battery module includes: a plurality of battery cells; a housing for receiving the plurality of battery cells; and a protection circuit module disposed at one side of the plurality of battery cells, the protection circuit module including: a substrate; a wire disposed on the substrate to form an opening in at least a portion of the wire and the wire including a first metal; a solder including a second metal having a melting point lower than a melting point of the first metal and the second metal inserted into at least a portion of the opening to join ends of the wire separated by the opening; and a cover forming at least one hole and covering at least a portion of the solder.

In some embodiments, the at least one hole is placed on the solder and provides a migration path for vaporized second metal upon vaporization of the second metal.

In some embodiments, the opening has a width of 1 mm to 4 mm.

In some embodiments, the melting point of the second metal is 200°C or higher.

In some embodiments, the second metal comprises at least one material selected from the group consisting of Al, Mg, Sb, Zn, Pb, Cd, Bi, and Sn.

In some embodiments, the cover comprises at least one material selected from the group consisting of polyethylene naphthalate (PEN), polyimide (PI), polyethylene terephthalate (PET), polytetrafluoroethylene (PTFE), polycarbonate (PC), and polyethersulphone (PES).

In some embodiments, the cover has a thickness of 0.015 mm to 0.060 mm.

In some embodiments, an area ratio of the at least one hole to the solder ranges from 0.4 to 0.65 in top plan view.

In some embodiments, the protection circuit module further comprises a connection plate electrically connected to a battery cell, wherein the opening is formed within 40 mm from the connection plate.

According to the technology described herein, it is possible to provide a protection circuit module and/or a battery module capable of detecting a trigger cell from which heat propagates even when heat propagates from a battery cell that is not provided with a temperature sensor.

According to the technology described herein, it is possible to provide a protection circuit module and/or a battery module capable of blocking external overcurrent in the event of heat propagation from a trigger cell.

According to the technology described herein, it is possible to provide a protection circuit module and/or a battery module capable of securing safety performance while reducing manufacturing costs.

However, aspects and features of the technology described herein are not limited to those described above and other aspects and features not mentioned will be clearly understood by those skilled in the art from the detailed description given below.

## BRIEF DESCRIPTION OF THE DRAWINGS

The following drawings attached to this specification illustrate embodiments of the technology described herein and further describe aspects and features of the technology together with the detailed description of the technology. Thus, the technology described herein should not be construed as being limited to the drawings:

FIGS. 1 to 4 are schematic views of a lithium battery, according to one embodiment of the technology described herein;
FIG. 5 is a perspective view of a battery module according to one embodiment of the technology described herein;
FIG. 6 is a schematic cross-sectional view of a fuse according to one embodiment of the technology described herein;
Fig. 7 is a graph depicting temperature change of a single battery cell and other battery cells adjacent thereto over time upon increase in temperature of the corresponding battery cell;
FIG. 8 is a schematic cross-sectional view of a fuse according to one embodiment of the technology described herein;
FIG. 9 is a schematic top plan view of the fuse according to the embodiment of the technology described herein;
FIG. 10 is a top plan view of a battery module according to one embodiment of the technology described herein; and
FIG. 11 is an enlarged view of Region A in Fig. 10.

## DETAILED DESCRIPTION

Hereinafter, exemplary embodiments of the technology described herein will be described in detail with reference to the accompanying drawings. However, it should be understood that the following embodiments are provided by way of illustration and the technology described herein is not limited thereto and is defined only by the appended claims and equivalents thereto.

When an arbitrary element is referred to as being disposed (or placed or placed) "above" (or "below") or "on" (or "under") a component, it may mean that the arbitrary element is placed in contact with the upper (or lower) surface of the component and may also mean that another component may be interposed between the component and any arbitrary element disposed (or placed or placed) on (or under) the component.

Throughout the specification, unless specified otherwise, each element may be singular or plural. In addition, throughout the specification, when "A and/or B" is stated, it means A, B or A and B, unless specified otherwise.

As used herein, "combinations thereof" may refer to mixtures, stacks, composites, copolymers, alloys, blends, and reaction products of components.

Unless otherwise defined herein, particle diameter may refer to an average particle diameter. In addition, the particle diameter means an average particle diameter (D50) that refers to a particle diameter corresponding to 50% by volume in a volume cumulative variation of corresponding particles. The average particle diameter may be measured by any method well known in the art, for example, by a particle size analyzer, a transmission electron microscope image, or a scanning electron microscope image. Alternatively, the average particle diameter (D50) may be measured by counting the number of particles in each particle diameter range using a device employing a dynamic light-scattering method to analyze data, followed by calculating the average particle diameter (D50) based on the analyzed data. Alternatively, the average particle diameter (D50) may be measured by laser diffraction. More specifically, in measurement by laser diffraction, target particles are dispersed in a dispersant, introduced into a commercially available laser diffraction particle analyzer (for example, Microtrac MT 3000), and irradiated with ultrasound waves of about 28 kHz at a power of 60 W, followed by calculating the average particle size (D50) corresponding to 50% by volume in the cumulative volume variation of the particles in the measurement device.

With development of technology, higher capacity batteries are required. Accordingly, a plurality of batteries may be electrically connected and used. For example, the batteries may be applied to electronic devices in the form of a battery module including a plurality of batteries and/or a battery pack including a plurality of battery modules. Here, the electronic devices refer to electronic devices requiring high power and/or high capacity, for example, electric vehicles.

A battery module includes a plurality of battery cells. Accordingly, a protection circuit module for managing the plurality of battery cells is required. The protection circuit module may check, for example, a charge state of each of the battery cells. Alternatively, the protection circuit module may measure, for example, a temperature of each of the battery cells. Alternatively, the protection circuit module may manage the plurality of battery cells by detecting, for example, whether the battery cells undergo overcurrent and/or short circuit.

The protection circuit module includes a fuse to perform all or some of the functions described above. The fuse measures the temperature of the battery cells, for example, through a temperature sensor, and interrupts power to each of the battery cells based on the measured temperature. However, in order to reduce manufacturing costs, a single temperature sensor is typically disposed per plurality of battery cells. Accordingly, when heat propagates from a certain battery cell not provided with the temperature sensor, there is difficulty detecting heat propagation from the battery cell.

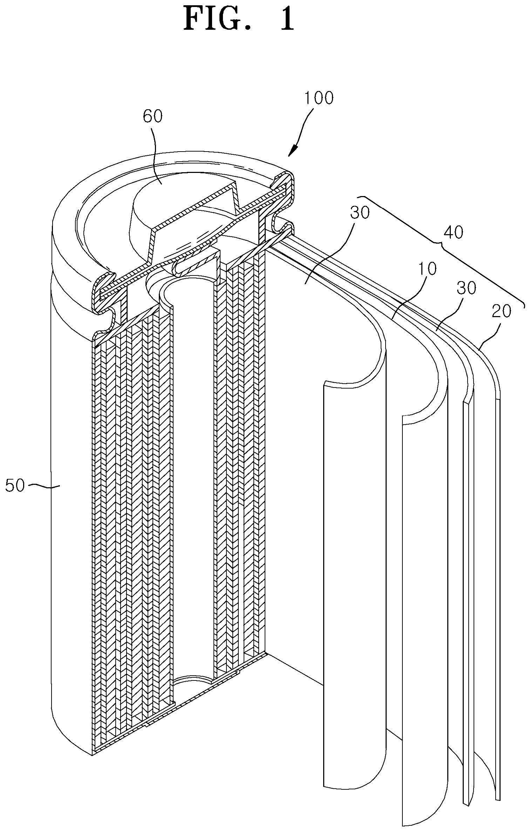

FIG. 1 to FIG. 4 are schematic views of lithium secondary batteries according to embodiments of the technology described herein.

## Lithium secondary battery 100

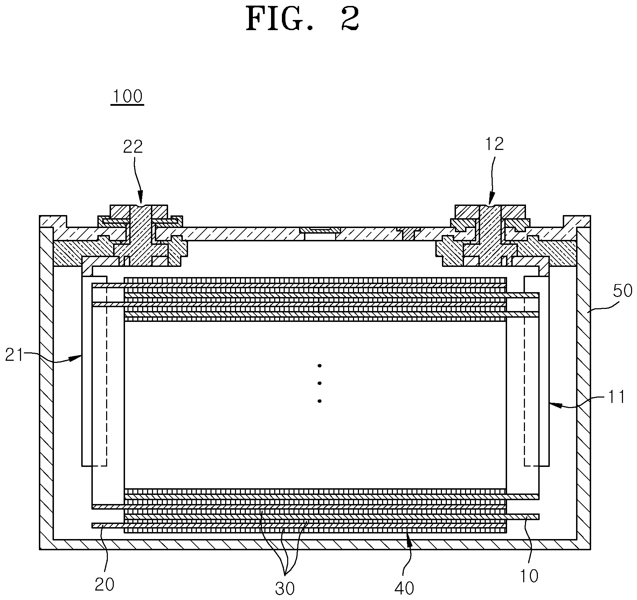

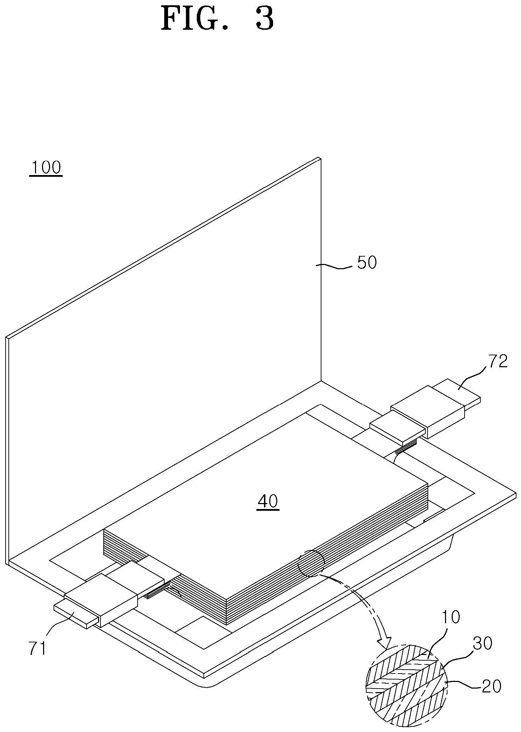

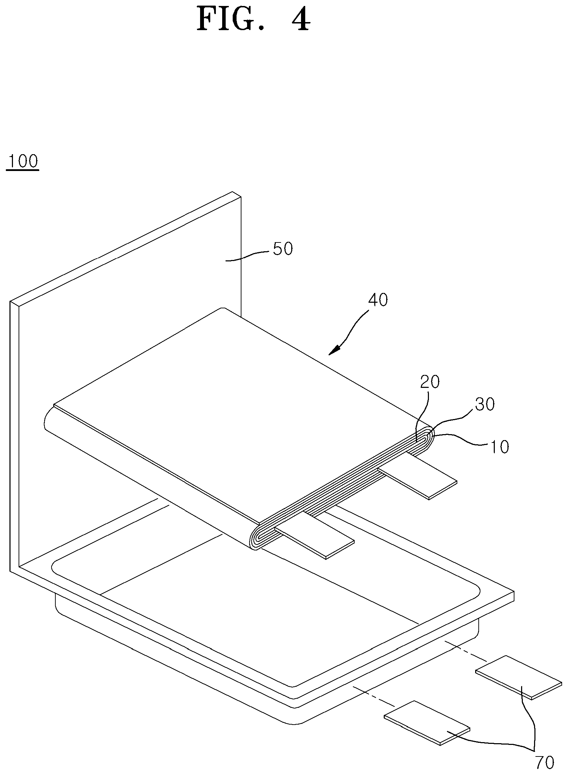

Lithium secondary batteries may be classified into a cylindrical secondary battery, a faceted secondary battery, a pouch type secondary battery, a coin type secondary battery, and the like based on the shapes thereof. FIG. 1 to FIG. 4 are schematic views of lithium secondary batteries according to embodiments of the technology described herein, in which FIG. 1 shows a cylindrical secondary battery, FIG. 2 shows a faceted secondary battery, and FIG. 3 and FIG. 4 show pouch-type secondary batteries. Referring to FIG. 1 to FIG. 4, a lithium secondary battery 100 may include an electrode assembly 40 in which a separator 30 is interposed between a cathode 10 and an anode 20, and a case 50 that receives the electrode assembly 40 therein. The cathode 10, the anode 20, and the separator 30 may be immersed in an electrolyte (not shown). The lithium secondary battery 100 may include a sealing member 60 that seals the case 50, as shown in FIG. 1. In addition, as shown in FIG. 2, the lithium secondary battery 100 may include a cathode lead tab 11, a cathode terminal 12, an anode lead tab 21, and an anode terminal 22. Referring to FIG. 3 and FIG. 4, the lithium secondary battery 100 may include electrode tabs 70, that is, a cathode tab 71 and an anode tab 72, which act as electrical pathways conducting current formed in the electrode assembly 40 to the outside.

## Cathode material

As a cathode material, a compound allowing reversible intercalation and deintercalation of lithium ion (lithiated intercalation compound) may be used. Specifically, the cathode material may be at least one complex oxide of a metal selected from among cobalt, manganese, nickel and combinations thereof with lithium.

The composite oxide may be a lithium transition metal composite oxide. Specifically, the lithium transition metal composite oxide may be a lithium nickel oxide, a lithium cobalt oxide, a lithium manganese oxide, a lithium iron phosphate compound, a cobalt-free nickel-manganese oxide, or a combination thereof.

By way of example, the composite oxide may be a compound represented by any of the following formulas: $Li_aA_{1-b}X_bO_{2-c}D_c$ ($0.90 \leq a \leq 1.8$, $0 \leq b \leq 0.5$, $0 \leq c \leq 0.05$); $Li_aMn_{2-b}X_bO_{4-c}D_c$ ($0.90 \leq a \leq 1.8$, $0 \leq b \leq 0.5$, $0 \leq c \leq 0.05$); $Li_aNi_{1-b-c}Co_bX_cO_{2-\alpha}D_\alpha$ ($0.90 \leq a \leq 1.8$, $0 \leq b \leq 0.5$, $0 \leq c \leq 0.5$, $0 < \alpha < 2$); $Li_aNi_{1-b-c}Mn_bX_cO_{2-\alpha}D_\alpha$ ($0.90 \leq a \leq 1.8$, $0 \leq b \leq 0.5$, $0 \leq c \leq 0.5$, $0 < \alpha < 2$); $Li_aNi_bCo_cL^1_d G_eO_2$ ($0.90 \leq a \leq 1.8$, $0 \leq b \leq 0.9$, $0 \leq c \leq 0.5$, $0 \leq d \leq 0.5$, $0 \leq e \leq 0.1$); $Li_aNiG_bO_2$ ($0.90 \leq a \leq 1.8$, $0.001 \leq b \leq 0.1$); $Li_aCoG_bO_2$ ($0.90 \leq a \leq 1.8$, $0.001 \leq b \leq 0.1$); $Li_aMn_{1-b}G_bO_2$ ($0.90 \leq a \leq 1.8$, $0.001 \leq b \leq 0.1$); $Li_aMn_2G_bO_4$ ($0.90 \leq a \leq 1.8$, $0.001 \leq b \leq 0.1$); $Li_aMn_{1-g}G_gPO_4$ ($0.90 \leq a \leq 1.8$, $0 \leq g \leq 0.5$); $Li_{(3-f)}Fe_2(PO_4)_3$ ($0 \leq f \leq 2$); and $Li_aFePO_4$ ($0.90 \leq a \leq 1.8$).

In the above formulas, A is Ni, Co, Mn, or a combination thereof; X is Al, Ni, Co, Mn, Cr, Fe, Mg, Sr, V, a rare-earth element, or a combination thereof; D is O, F, S, P, or a combination thereof; G is Al, Cr, Mn, Fe, Mg, La, Ce, Sr, V, or a combination thereof; and $L^1$ is Mn, Al, or a combination thereof.

In one embodiment, the cathode material may be a high nickel-content cathode material containing 80 mol% or more, 85 mol% or more, 90 mol% or more, 91 mol% or more, or 94 mol% to 99 mol% of nickel relative to 100 mol% of metal excluding lithium in the lithium transition metal complex oxide. The high nickel-content cathode material can achieve high capacity and thus can be applied to high capacity/high density lithium secondary batteries.

## Cathode 10

The cathode 10 for the lithium secondary battery 100 may include a cathode current collector and a cathode material layer formed on the cathode current collector. The cathode material layer includes a cathode material and may further include a binder and/or a conductive material.

In one embodiment, the cathode may further include an additive capable of acting as a sacrificial cathode.

The cathode material may be present in an amount of 90 wt% to 99.5 wt% based on 100 wt% of the cathode material layer and each of the binder and the conductive material may be present in an amount of 0.5 wt% to 5 wt% based on 100 wt% of the cathode material layer.

The binder serves to attach cathode material particles to each other while attaching the cathode material to the cathode current collector. The binder may include, for example, polyvinyl alcohol, carboxymethylcellulose, hydroxypropylcellulose, diacetylcellulose, polyvinyl chloride, carboxylated polyvinyl chloride, polyvinyl fluoride, polymers including ethylene oxide, polyvinyl pyrrolidone, polyurethane, polytetrafluoroethylene, polyvinylidene fluoride, polyethylene, polypropylene, styrene-butadiene rubbers, (meth)acrylated styrene-butadiene rubbers, epoxy resins, (meth)acrylic resins, polyester resins, Nylon, and the like, without being limited thereto.

The conductive material serves to impart conductivity to the electrodes and may be any electrically conductive material that does not cause chemical change in cells under construction. The conductive material may include, for example, carbon materials, such as natural graphite, artificial graphite, carbon black, acetylene black, Ketjen black, carbon fiber, carbon nanofibers, carbon nanotubes, and the like; metal-based materials in the form of metal powders or metal fibers containing copper, nickel, aluminum, silver, and the like; conductive polymers, such as polyphenylene derivatives and the like; and mixtures thereof.

The cathode current collector may be Al foil, without being limited thereto.

## Anode material

The anode material includes a material allowing reversible intercalation/deintercalation of lithium ions, lithium metal, lithium metal alloy, a material capable of being doped to lithium and de-doped therefrom, or a transition metal oxide.

The material allowing reversible intercalation/deintercalation of lithium ions may include a carbon-based anode material, for example, crystalline carbon, amorphous carbon, or a combination thereof. The crystalline carbon may include, for example, graphite, such as natural graphite or artificial graphite, in amorphous, plate, flake, spherical, or fibrous form, and the amorphous carbon may include, for example, soft carbon, hard carbon, mesoporous pitch carbides, calcined coke, and the like.

The lithium metal alloy may be an alloy of lithium and a metal selected from among Na, K, Rb, Cs, Fr, Be, Mg, Ca, Sr, Si, Sb, Pb, In, Zn, Ba, Ra, Ge, Al and Sn may be used.

The material capable of being doped to lithium and de-doped therefrom may be an Si-based anode material or an Sn-based anode material. The Si-based anode material may be silicon, a silicon-carbon composite, $SiO_x$ ($0<x \leq 2$), Si-Q alloys (where Q is selected from among alkali metals, alkali-earth metals, Group XIII elements, Group XIV elements (excluding Si), Group XV elements, Group XVI elements, transition metals, rare-earth elements, and combinations thereof), or combinations thereof. The Sn-based anode material may be Sn, $SnO_x$ ($0<x \leq 2$) (e.g., $SnO_2$), an Sn alloy, or a combination thereof.

The silicon-carbon composite may be a composite of silicon and amorphous carbon. According to one embodiment, the silicon-carbon composite may be prepared in the form of silicon particles having an amorphous carbon coating formed on the surface thereof. For example, the silicon-carbon composite may include secondary particles (cores) composed of primary silicon particles and an amorphous carbon coating layer (shell) formed on the surface of the secondary particle. The amorphous carbon may also be placed between the primary silicon particles such that, for example, the primary silicon particles are coated with amorphous carbon. The secondary particles may be dispersed in an amorphous carbon matrix.

The silicon-carbon composite may further include crystalline carbon. For example, the silicon-carbon composite may include a core containing crystalline carbon and silicon particles, and an amorphous carbon coating layer formed on the core.

The Si-based anode material or the Sn-based anode material may be used in combination with the carbon-based anode material.

## Anode 20

The anode 20 for the lithium secondary battery 100 may include an anode current collector and an anode material layer formed on the anode current collector. The anode material layer includes an anode material and may further include a binder and/or a conductive material.

For example, the anode material layer may include 90 wt% to 99 wt% of the anode material, 0.5 wt% to 5 wt% of the binder, and 0 wt% to 5 wt% of the conductive material.

The binder serves to attach the anode material particles to each other while attaching the anode material to the anode current collector. The binder may be a non-aqueous binder, an aqueous binder, a dry binder, or a combination thereof.

The non-aqueous binder includes polyvinyl chloride, carboxylated polyvinyl chloride, polyvinyl fluoride, ethylene propylene copolymers, polystyrene, polyurethane, polytetrafluoroethylene, polyvinylidene fluoride, polyethylene, polypropylene, polyamideimide, polyimide, or combinations thereof.

The aqueous binder may be selected from the group consisting of styrene-butadiene rubbers, (meth)acrylated styrene-butadiene rubbers, (meth)acrylonitrile-butadiene rubbers, (meth)acrylic rubbers, butyl rubbers, fluorinated rubbers, polyethylene oxide, polyvinyl pyrrolidone, polyepichlorohydrin, polyphosphazene, poly(meth)acrylonitrile, ethylene propylene diene copolymers, polyvinyl pyridine, chlorosulfonated polyethylene, latex, polyester resins, (meth)acryl resins, phenol resins, epoxy resins, polyvinyl alcohol, and combinations thereof.

When the aqueous binder is used as the anode binder, a cellulose-based compound capable of imparting viscosity may be further included. The cellulose-based compound may be a mixture of carboxymethylcellulose, hydroxypropyl methylcellulose, methylcellulose, or alkali metal salts thereof. The alkali metal may be Na, K, or Li.

The dry binder may be a fibrous polymeric material and may include, for example, polytetrafluoroethylene, polyvinylidene fluoride, a polyvinylidene fluoride-hexafluoropropylene copolymer, polyethylene oxide, or a combination thereof.

The conductive material serves to impart conductivity to the electrodes and may be any electronically conductive material that does not cause chemical change in cells under construction. Specifically, the conductive material may include, for example, carbon materials, such as natural graphite, artificial graphite, carbon black, acetylene black, Ketjen black, carbon fibers, carbon nanofibers, carbon nanotubes, and the like; metal-based materials in the form of metal powders or metal fibers containing copper, nickel, aluminum, silver, and the like; conductive polymers, such as polyphenylene derivatives and the like; or mixtures thereof.

The anode current collector may be selected from copper foil, nickel foil, stainless steel foil, titanium foil, nickel foam, copper foam, a conductive metal-coated polymer base, and combinations thereof.

## Electrolyte (not shown)

The electrolyte for the lithium secondary battery 100 includes a non-aqueous organic solvent and a lithium salt.

The non-aqueous organic solvent acts as a medium through which ions involved in electrochemical reaction of a cell can move.

The non-aqueous organic solvent may be a carbonate-based solvent, an ester-based solvent, an ether-based solvent, a ketone-based solvent, an alcohol-based solvent, a non-amphoteric solvent, or a combination thereof.

The carbonate-based solvents may include dimethyl carbonate (DMC), diethyl carbonate (DEC), dipropyl carbonate (DPC), methyl propyl carbonate (MPC), ethyl propyl carbonate (EPC), methyl ethyl carbonate (MEC), ethylene carbonate (EC), propylene carbonate (PC), and/or butylene carbonate (BC).

The ester-based solvents may include methyl acetate, ethyl acetate, n-propyl acetate, dimethyl acetate, methyl propionate, ethyl propionate, decanolide, mevalonolactone, valerolactone, caprolactone, and the like.

The ether-based solvents may include dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone and the like. The alcohol-based solvents may include ethyl alcohol, isopropyl alcohol, and the like, and non-amphoteric solvent may include nitriles, such as R-CN (where R is a straight, branched or cyclic hydrocarbon group having 2 to 20 carbon atoms and may include double bonds, aromatic rings, or ether groups); amides, such as dimethylformamide; dioxolanes, such as 1,3-dioxolane, 1,4-dioxolane, and the like; sulfolanes; and the like.

The non-aqueous organic solvent may be used alone or as a mixture thereof.

In use of the carbonate-based solvent, a mixture of a cyclic carbonate and a chained carbonate may be used, and the cyclic carbonate and the chained carbonate may be mixed in a volume ratio of 1:1 to 1:9.

The lithium salt is a substance that is soluble in an organic solvent and serves as a source of lithium ions in a battery, enabling operation of a basic lithium secondary battery while facilitating transfer of the lithium ions between the cathode and the anode. Examples of the lithium salts may include at least one selected from among $LiPF_6$, $LiBF_4$, $LiSbF_6$, $LiAsF_6$, $LiClO_4$, $LiAlO_2$, $LiAlCl_4$, $LiPO_2F_2$, LiCl, LiI, $LiN(SO_3C_2F_5)_2$, $Li(FSO_2)_2N$ (lithium bis(fluorosulfonyl)imide (LiFSI)), $LiC_4F_9SO_3$, $LiN(C_xF_{2x+1}SO_2)(C_yF_{2y+1}SO_2)$ (where x and y are integers of 1 to 20), lithium trifluoromethane sulfonate, lithium tetrafluoroethane sulfonate, lithium difluorobis(oxalato)phosphate (LiDFOB), and lithium bis(oxalato)borate (LiBOB).

## Separator 30

Depending on the type of lithium secondary battery 100, a separator 30 may be interposed between the cathode 10 and the anode 20. For such a separator 30, polyethylene, polypropylene, polyvinylidene fluoride, or at least two layers thereof may be used as well as mixed layers, such as a polyethylene/polypropylene bilayer separator, a polyethylene/polypropylene/polyethylene trilayer separator, a polyethylene/polyethylene/polypropylene trilayer separator, and the like.

The separator 30 may include a porous substrate and a coating layer that includes an organic material, an inorganic material, or a combination thereof on one or both surfaces of the porous substrate.

The porous substrate may be a polymer layer formed of a polymer selected from among polyolefins, such as polyethylene polypropylene, and the like, polyesters, such as polyethylene terephthalate, polybutylene terephthalate, and the like, polyacetal, polyamides, polyimides, polycarbonates, polyether ketones, polyarylether ketones, polyetherimides, polyamideimides, polybenzimidazole, polyethersulfone, polyphenylene oxides, cyclic olefin copolymers, polyphenylene sulfides, polyethylene naphthalate, glass fiber, Teflon, and polytetrafluoroethylene, copolymers thereof, or mixtures thereof.

The organic material may include a polyvinylidene fluoride polymer or a (meth)acrylic polymer.

The inorganic material may include inorganic particles selected from among $Al_2O_3$, $SiO_2$, $TiO_2$, $SnO_2$, $CeO_2$, MgO, NiO, CaO, GaO, ZnO, $ZrO_2$, $Y_2O_3$, $SrTiO_3$, $BaTiO_3$, $Mg(OH)_2$, boehmite, and combinations thereof, without being limited thereto.

The organic material and the inorganic material may be present in a mixed state in one coating layer or may be present in the form of a stack structure of a coating layer including the organic material and a coating layer including the inorganic material.

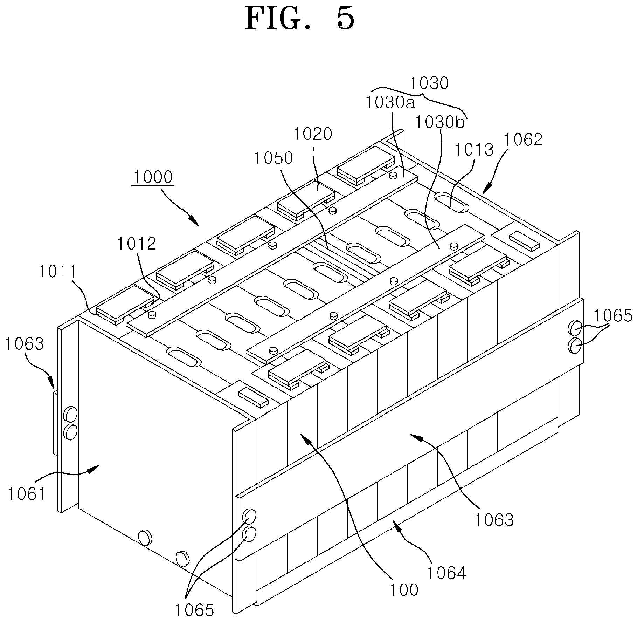

FIG. 5 is a perspective view of a battery module according to one embodiment of the technology described herein.

A battery module 1000 according to one embodiment of the technology described herein includes a plurality of battery cells 100, a housing 1061, 1062, 1063, 1064, 1065 that receives the plurality of battery cells 100 therein, and a busbar electrically connecting at least some of the plurality of battery cells 100 to each other.

The plurality of battery cells 100 may include, for example, the battery cells illustrated in FIG. 1 to FIG. 4, and may be arranged in one direction and received within the housing 1061 to 1065.

The housing 1061 to 1065 may include a pair of end plates 1061, 1062 facing wide surfaces of the battery cells 100, and side plates 1063 and a bottom plate 1064 each connecting the pair of end plates 1061, 1062 to each other. The side plates 1063 may support side surfaces of each of the battery cells 100 and the bottom plate 1064 may support a bottom surface of each of the battery cells 10. In addition, the pair of end plates 1061, 1062, the side plates 1063 and the bottom plates 1064 may be connected to one another by members, such as bolts 1065 or the like.

The battery module 100 includes terminals 1011, 1012, connection tabs 1020 connecting adjacent battery cells 100 to each other, and a protection circuit module 1030 connected at one side thereof to the connection tabs 1020. The protection circuit module 1030 may be a battery management system (BMS). The connection tabs 1020 may be busbars.

Each of the battery cells 100 may be provided at one side thereof with terminals 1011, 1012 electrically connected to the connection tab 1020 and may be formed with a vent 1013, which is a discharge channel of gas generated therein. The terminals 1011, 1012 of the battery cell 100 may be a cathode terminal 1011 and an anode terminal 1012, respectively, and the terminals 1011, 1012 of adjacent battery cells 100 may be electrically connected in series or in parallel by the connection tab 1020 described below. Although a series connection is described above by way of example, it should be understood that various connection structures may be used, as needed. In addition, it should be understood that the number and arrangement of battery cells are not limited to the structure of FIG. 3 and may be changed, as needed.

The protection circuit module (PCM) 1030 may have electronic components and protection circuits mounted thereon and may be electrically connected to the connection tabs 1020 described below. The protection circuit module 1030 may include a first protection circuit module 1030a and a second protection circuit module 1030b extending from different locations in an arrangement direction of the battery cells 100, in which the first protection circuit module 1030a and the second protection circuit module 1030b may be spaced apart parallel to each other by a constant distance and each may be electrically connected to the connection tabs 1020 adjacent thereto. For example, the first protection circuit module 1030a extends at one side of upper portions of the plurality of battery cells 100 in the arrangement direction of the battery cells 100 and the second protection circuit module 1030b extends at the other side of the upper portion of the battery cells 100 in the arrangement direction of the battery cells 100 such that the second protection circuit module 1030b is spaced apart from the first protection circuit module 1030a, with the vents 1013 disposed therebetween, while being parallel to the first protection circuit module 1030a. As such, the two protection circuit modules are spaced apart from each other in the arrangement direction of the battery cells 100, thereby minimizing the area of the printed circuit board (PCB) constituting the protection circuit module 1030. An unnecessary PCM area is minimized by dividing the protection circuit module 1030 into two separate protection circuit modules. In addition, the first protection circuit module 1030a and the second protection circuit module 1030b may be connected to each other by a conductive connection member 1050. The connection member 1050 is connected at one side thereof to the first protection circuit module 1030a and at the other side thereof to the second protection circuit module 1030b, whereby the two protection circuit modules can be electrically connected.

The connection may be realized by any one of soldering, resistance welding, laser welding, or projection welding.

The connection member 1050 may be, for example, an electrical wire. In addition, the connecting member 1050 may include an elastic or flexible material. Through the connection member 1050, the voltage, temperature, and current of the battery cells 100 can be checked and managed to be normal. That is, information, such as voltage, current, and temperature, received by the first protection circuit module 1030a from the connection tabs adjacent thereto and information, such as voltage, current, and temperature, received by the second protection circuit module 1030b from the connection tabs adjacent thereto may be integrated and managed by the protection circuit module through the connection member.

In addition, upon swelling of the battery cells 100, impact can be absorbed by elasticity or flexibility of the connection member 1050 to prevent damage to the first and second protection circuit modules 1030a, 1030b

Further, the shape and structure of the connecting member 1050 are not limited to those shown in FIG. 5.

As such, the structure of the protection circuit module 1030 divided into the first and second protection circuit modules 1030a, 1030b can secure an interior space of the battery module by minimizing the area of the PCB that constitutes the protection circuit module. As a result, it is possible to improve work efficiency by facilitating not only operation of connecting the connection tabs 1020 to the protection circuit module 1030, but also repair upon detection of failure of the battery module 1000.

FIG. 5 illustrates the protection circuit module 1030 applied to the battery module 1000 including a plurality of battery cells 100 illustrated in FIG. 1 to FIG. 4. The protection circuit module 1030 protects and/or manages the battery cells 100 in the battery module 1000, as described above. For example, the protection circuit module 1030 monitors the state of each of the battery cells 100 to ensure that each of the battery cells 100 is charged or discharged under optimal conditions. Monitoring includes, for example, any behavior that measures and/or manages the voltage, current, temperature, and/or the like of each of the battery cells 100. Based on these measurements, the protection circuit module 1030 can predict a charge state and/or lifespan of each of the battery cells 100. For example, the protection circuit module 1030 may control each of the battery cells 100 to prevent occurrence of overcharge, over-discharge and/or overcurrent. Alternatively, for example, the protection circuit module 1030 may act to reduce a deviation between the battery cells 100.

The protection circuit module 1030 includes electrical components for measuring the state of the battery cells 100. The electrical components include, for example, a wire harness, a flexible printed circuit assembly (FPCA), and a flexible die-cut circuit (FDC). The protection circuit module 1030 may include a wire harness as an electrical component when the battery module 1000 includes a relatively small number of battery cells 100. Alternatively, the protection circuit module 1030 may include an FPCA and/or an FDC as electronic components when the battery module 1000 includes a relatively large number of battery cells 100.

The protection circuit module 1030 may include a fuse, which is a safety device to prevent fire from spreading to adjacent circuits in the event of overcurrent and/or electric short in the battery module 1000 and/or each of the battery cells 100.

For example, the temperature of one of the battery cells 100 can increase. Herein, a cell having an increased temperature will be referred to as a trigger cell. The fuse identifies (e.g., determines) a trigger cell. The fuse blocks heat propagation between the plurality of battery cells 100. Specifically, the fuse prevents heat from propagating from the trigger cell to other battery cells by interrupting power between the electrical components.

The protection circuit module 1030 including such a fuse will be described in more detail. Specifically, the protection circuit module 1030 including a fuse that detects the trigger cell and/or blocks heat propagation between the battery cells will be described.

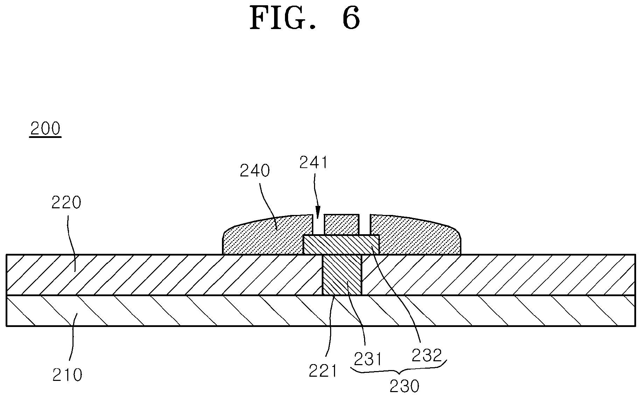

FIG. 6 is a schematic cross-sectional view of a fuse according to one embodiment of the technology described herein.

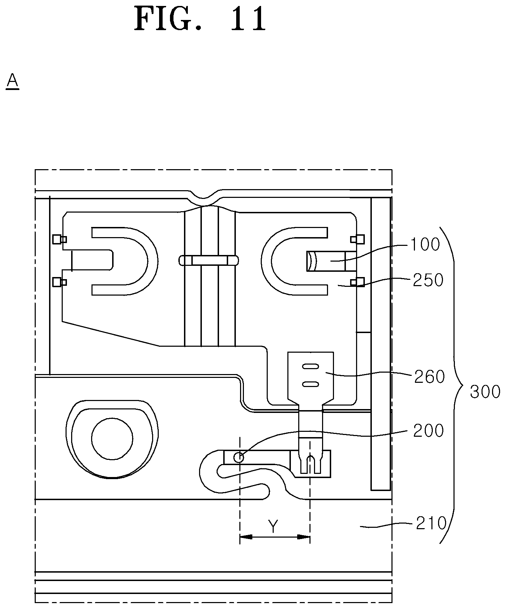

A protection circuit module 300 (see FIG. 11) (for example, including the protection circuit module 1030 described in FIG. 5) according to one embodiment of the technology described herein includes a substrate 210 with a wire 220 arranged thereon and a fuse formed on the substrate 210.

In FIG. 6, reference numeral 200 denotes a fuse (for example, the fuse illustrated in FIG. 5) according to one embodiment of the technology described herein. The fuse 200 detects a trigger cell. The fuse 200 also prevents heat from propagating from the trigger cell towards other battery cells.

To this end, the fuse 200 according to the embodiment of the technology described herein includes the wire 220, which forms an opening 221 in at least a portion thereof, a solder 230 inserted into the opening 221 to join (e.g., at least partially fill) the opening 221, and a cover 240 covering at least a portion of the solder 230.

The wire 220 is disposed on the substrate 210. For example, the wire 220 is printed on the substrate 210.

The substrate 210 is placed at one side of the plurality of battery cells 100. The substrate 210 may extend in the arrangement direction of the battery cells 100. The substrate 210 may be referred to as, for example, a flexible printed circuit assembly (FPCA), a flexible printed circuit board (FPCB), a flexible die-cut circuit (FDC), or the like. The substrate 210 may include, for example, PI, PEN, and the like.

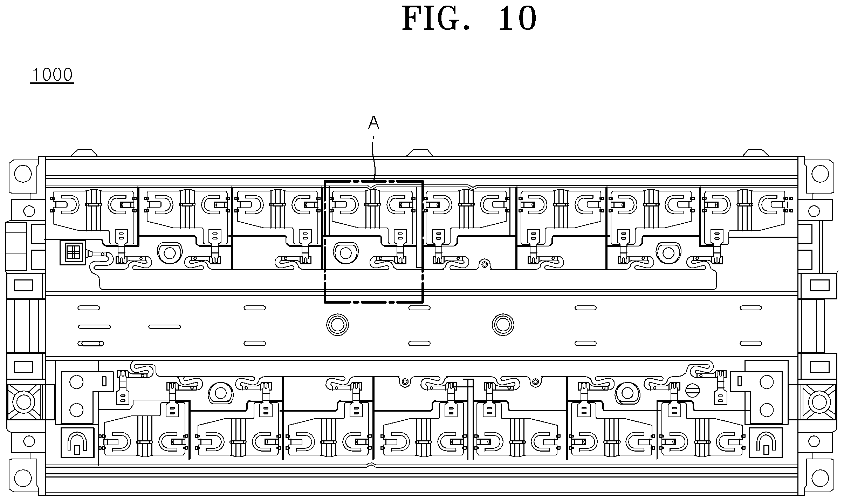

The wire 220 is disposed on the substrate 210 and is electrically connected to the battery cells 100, which are electrically connected to the substrate 210. For example, the wire 220 is electrically connected to the battery cells 100 through busbars. The busbar will be described in more detail with reference to FIG. 10 and FIG. 11.

To this end, the wire 220 includes a first metal. The first metal includes a conductive material. The first metal includes, for example, a metal. The first metal includes, for example, copper (Cu), silver (Ag), gold (Au), molybdenum (Mo), cobalt (Co), nickel (Ni), manganese (Mn), platinum (Pt), and/or the like. The wire 220 will be described below with reference to an example in which the wire 220 includes copper (Cu).

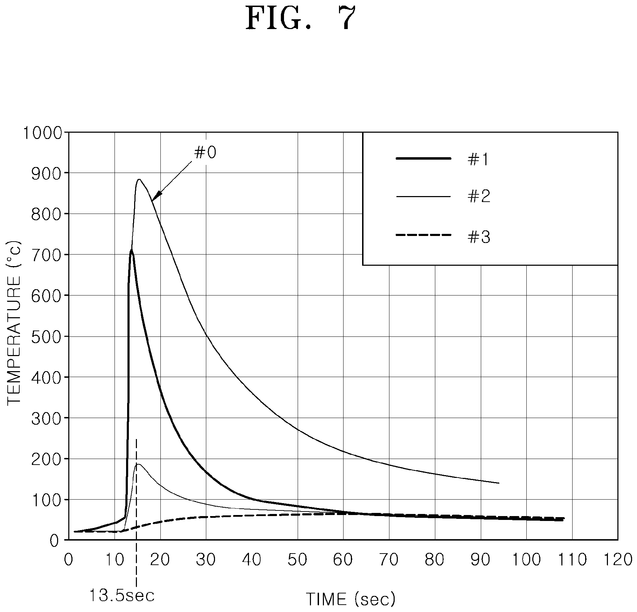

On the other hand, when the first metal melts upon increase in temperature of the battery module 1000, the voltage supplied to all of the battery cells 100 in the battery module 1000 can be interrupted despite operation of the fuse 200. Accordingly, the first metal may include, for example, a metal having a relatively high melting point so as not to melt even upon increase in interior temperature of the battery module 1000. The melting point of the first metal will be described in more detail with reference to FIG. 7.

The wire 220 forms the opening 221 in at least a portion thereof. The wire 220 forms an open circuit through the opening 221.

The solder 230 is inserted into at least a portion of the opening 221 formed in the wire 220. The solder 230 is inserted into the opening 221 to join the wire 220 exposed through the opening 221. For example, the solder 230 includes a first solder 231 inserted into the opening 221. The first solder 231 may fill the entirety of the opening 221 to allow the wire 220 to be electrically connected to an electric component. Alternatively, the first solder 231 may fill a portion of the opening 221 while allowing the wire 220 to be electrically connected thereto. Alternatively, for example, the solder 230 includes a second solder 232 disposed in a region adjacent to the opening 221. The second solder 232 is disposed in a region adjacent to an upper portion of the opening 221, for example, at an upper portion of the wire 220. The second solder 232 assists in bonding and electrical connection of the wire 220. The wire 220 allows current to continuously flow through the solder 230 without being interrupted.

The solder 230 includes a second metal. The second metal includes a conductive material. The second metal includes, for example, a metal. The second metal may, for example, melt and vaporize to disconnect the wire 220 upon increase in temperature of the battery cell 100. To this end, the second metal is configured to melt upon increase in temperature of the battery cell 100. Accordingly, the second metal includes a metal having a lower melting point than the first metal. However, the second metal is configured not to melt upon operation of the battery cells 100 under normal conditions (for example, charging and discharging of the battery cell 100 at 120°C or less). When the second metal melts in operation of the battery cells 100 under normal conditions, normal operation of the battery cells 100 can be interrupted. Thus, it is desirable that the second metal have a higher melting point than the temperatures of the battery cells 100 under normal operation conditions. For example, the second metal has a melting point of 200°C or higher. The second metal includes at least one selected from the group consisting of, for example, Al, Mg, Sb, Zn, Pb, Cd, Bi, and Sn.

The cover 240 covers at least a portion of the solder 230. For example, the cover 240 is formed over the entire region in which the solder 230 is formed. In top plan view, the cover 240 may have a larger area than the solder 230. For example, the cover 240 may cover the entire region in which the solder 230 is formed and an upper portion of the wire 220 adjacent to the solder 230. Alternatively, the cover 240 may also have a smaller area than or the same area as the solder 230 in top plan view.

The cover 240 provides a migration path of the second metal in the event that the second metal melts, as described below. Accordingly, the cover 240 is configured to maintain the shape thereof and not to melt together when the second metal melts.

The cover 240 includes a heat resistant material. The cover 240 includes at least one material selected from the group consisting of, for example, polyethylene naphthalate (PEN), polyimide (PI), polyethylene terephthalate (PET), polytetrafluoroethylene (PTFE), polycarbonate (PC), polyethersulphone (PES), and combinations thereof.

Alternatively, the cover 240 may include an insulating material. The cover 240 may include at least one material selected from the group consisting of, for example, aramid fiber, polybenzimidazole (PBI), polyimide (PI), glass fiber, carbon fiber, grass wool, mineral wool, silica, perlite, urethane foam, ceramic fiber, polytetrafluoroethylene (PTFE), mica, and combinations thereof.

The cover 240 is formed to a thickness of, for example, 0.015 mm to 0.060 mm. If the thickness of the cover 240 is less than 0.015 mm, the cover 240 may not properly provide the migration path of the second metal. If the thickness of the cover 240 is greater than 0.060 mm, the cover 240 becomes too thick, causing deterioration in capacity of the battery cells 100. Thus, for example, the cover 240 may be formed to a thickness of 0.015 mm to 0.060 mm. Alternatively, for example, the cover 240 may be formed to a thickness of 0.020 mm to 0.060 mm. Alternatively, for example, the cover 240 may be formed to a thickness of 0.015 mm to 0.055 mm. Alternatively, for example, the cover 240 may be formed to a thickness of 0.020 mm to 0.055 mm. Alternatively, for example, the cover 240 may be formed to a thickness of 0.015 mm to 0.050 mm. Alternatively, for example, the cover 240 may be formed to a thickness of 0.020 mm to 0.050 mm.

The cover 240 forms a hole 241. The hole 241 is formed through the cover 240. The cover 240 may be formed to penetrate from an upper portion of the solder 230 to an upper portion of the cover 240.

The cover 240 may include one hole 241 or a plurality of holes 241. The one hole 241 or at least some of the holes 241 formed in the cover 240 are disposed on the solder 230. As described above, upon increase in temperature of the battery cell 100, the solder 230 can melt and vaporize. The holes 241 provide a migration path of the vaporized second metal to allow the vaporized second metal to escape from the solder 230.

With this configuration, the fuse 200 according to the embodiment of the technology described herein allows the vaporized second metal to be exposed to the outside. Accordingly, the fuse 200 can provide a means for interrupting electrical connection to each or all of the battery cells 100 by checking heat propagation due to increase in temperature of the battery cells 100.

Fig. 7 is a graph depicting temperature change of a single battery cell and other battery cells adjacent thereto over time upon increase in temperature of the corresponding battery cell.

FIG. 7 is a graph representing results of an experiment to extract detailed data for each component included in the fuse 200. The graph of FIG. 7 shows the temperature change of surrounding battery cells over time after the temperature of the trigger cell increases.

In Fig. 7, the horizontal axis indicates time (sec) and the vertical axis indicates temperature (°C). Here, 0 seconds indicates the time when the trigger cell starts to heat up.

In FIG. 7, #0 indicates the trigger cell.

In FIG. 7, #1 indicates a battery cell closest to the trigger cell (hereinafter referred to as "adjacent cell"). In FIG. 7, #2 indicates a battery cell, which is closest to the adjacent cell and is not the trigger cell (hereinafter referred to as "third cell"). In FIG. 7, #3 indicates a battery cell, which is closest to the third cell and is not the adjacent cell (hereinafter referred to as "other cell").

As shown in FIG. 7, the trigger cell #0 reaches a peak temperature of 890°C in the event of heat propagation.

As shown in FIG. 7, the adjacent cell #1 undergoes a peak temperature of about 710°C in the event of heat propagation from the trigger cell #0. The third cell #2 also undergoes a peak temperature of about 180°C in the event of heat propagation from the trigger cell #0. In addition, the other cell #3 has a peak temperature of less than 100°C even upon heat propagation from the trigger cell #0, thereby exhibiting substantially no temperature change.

In this case, the wire 220 is required to open with respect to the adjacent cell #1 such that the fuse 200 interrupts electrical connection to the adjacent cell #1. On the other hand, the wire 220 is required not to open with respect to the third cell #2 and/or the other cell #3 such that the fuse 200 does not interrupt electrical connection to the third cell #2 and/or the other cell #3.

Accordingly, the solder 230 included in the fuse 200 may have a lower melting point than the peak temperature of the adjacent cell #1. Further, the solder 230 may have a higher melting point than the peak temperature of the third cell #2 and the other cell #3. In this case, the peak temperature may have a tolerance of ±20°C since the peak temperature can vary depending on situation. Accordingly, for example, the second metal includes a conductive material having a melting point of 200°C or higher. Table 1 shows melting points (°C) of metals.

Table 1

| Metal | Melting point (°C) | Metal | Melting point (°C) |
|---|---|---|---|
| Cr | 1,890±10 | Al | 660.2±0.1 |
| Pt | 1,773.5±1 | Mg | 650±2 |
| Fe | 1,539±3 | Sb | 630.5±0.1 |
| Co | 1,495±1 | Zn | 419.46 |
| Ni | 1,455±1 | Pb | 327.4±0.1 |
| Mn | 1,245±10 | Cd | 320.9±0.1 |
| Cu | 1,083±0.1 | Bi | 271.3±0.1 |
| Au | 1,063 | Sn | 231.9±1 |
| Ag | 960.5 | | |

As can be seen from Table 1, metals having melting points that are lower than the peak temperatures of the adjacent cell #1 and higher than the peak temperature of the third cell #2 and the other cell #3 include, for example, Al, Mg, Sb, Zn, Pb, Cd, Bi, Sn, and the like. Thus, the second metal includes at least one material selected from the group consisting of, for example, Al, Mg, Sb, Zn, Pb, Cd, Bi, Sn, and alloys thereof.

Here, when the wire 220 includes Cu, the second metal may be, for example, Pb. This is because Cu and Pb have good bonding reliability and Pb can be prepared by simply applying solder pastes in an SMT process.

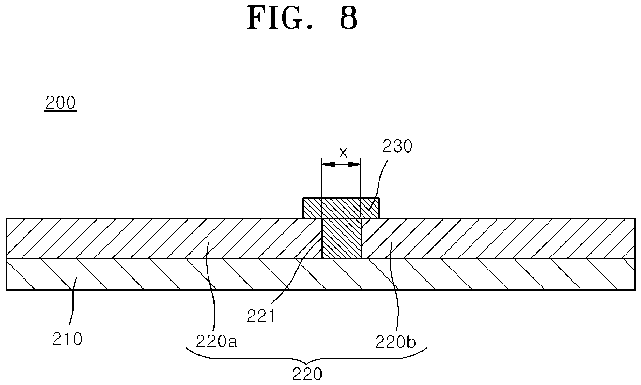

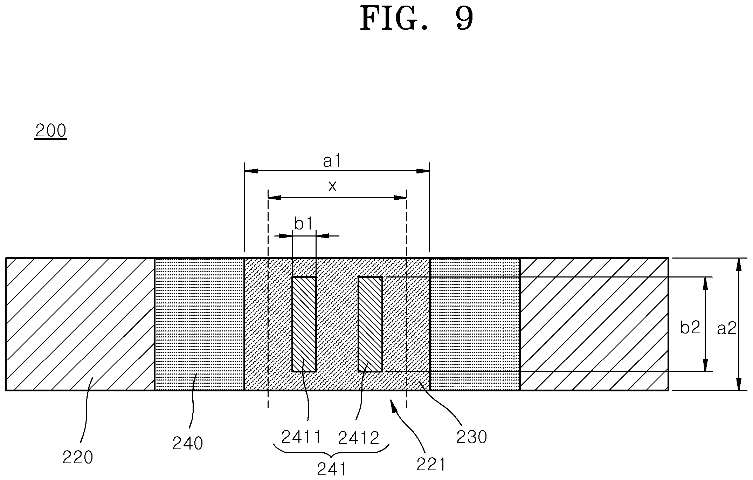

As shown in FIG. 7, it can be seen that the third cell #2 reaches the peak temperature after 13.5 seconds (sec) have elapsed. Based on such experimental data, each of the components included in the fuse 200 will be described in detail with reference to FIG. 8 and FIG. 9.

FIG. 8 is a schematic cross-sectional view of a fuse according to one embodiment of the technology described herein.

FIG. 8 shows the width of the opening 221 formed in the wire 220. As described with reference to FIG. 6, the wire 220 may be open through the opening 221. For convenience of description, a portion of the wire 220 placed at one side of the opening 221 will be referred to as a first wire 220a and a portion of the wire 220 placed at the other side of the opening 221 will be referred to as a second wire 220b. Here, the width x of the opening 221 indicates the shortest distance between the first wire 220a and the second wire 22b.

Referring to FIG. 7, it can be seen that the third cell #2 does not reach the peak temperature thereof until 13.5 seconds after the trigger cell starts to generate heat. Thus, the fuse 200 according to the embodiment of the technology described herein can protect most of the battery cells 100 in the battery module 1000 by interrupting electrical connection to the trigger cell before the third cell #2 reaches the peak temperature thereof.

To this end, the wire 220 may be formed to a width of 4 mm or less. When the width x of the wire 200 exceeds 4 mm, the amount of solder 230 inserted into the opening 221 can become excessive. In this case, it can take a long period of time for the solder 230 to melt and form an open circuit. Alternatively, the wire 220 may be formed to a width of, for example, 0.1 mm or more. Alternatively, the wire 220 may be formed to a width of, for example, 0.2 mm or more. Alternatively, the wire 220 may be formed to a width of, for example, 0.3 mm or more. Alternatively, the wire 220 may be formed to a width of, for example, 0.4 mm or more. Alternatively, the wire 220 may be formed to a width of, for example, 0.5 mm or more. Alternatively, the wire 220 may be formed to a width of, for example, 0.6 mm or more. Alternatively, the wire 220 may be formed to a width of, for example, 0.7 mm or more. Alternatively, the wire 220 may be formed to a width of, for example, 0.8 mm or more. Alternatively, the wire 220 may be formed to a width of, for example, 0.9 mm or more. Alternatively, the wire 220 may be formed to a width of, for example, 1.0 mm or more. When the width of the wire 220 is less than 0.1 mm, the distance between the first wire 220a and the second wire 220b can become too close for the wire 220 to form an open circuit even when the solder 230 melts. Thus, the wire 220 may be formed to a width of, for example, 0.1 mm to 4 mm. Alternatively, the wire 220 may be formed to a width of 1.0 mm to 4 mm.

With this structure, the fuse 200 according to the embodiment of the technology described herein can promptly detect and prevent heat propagation from the trigger cell toward the battery cells within the battery module 1000.

Furthermore, the fuse 200 according to the embodiment of the technology described herein can prevent heat propagation from the battery cell 100, which is not provided with a temperature sensor, through the solder 230 and the cover 240, even upon increase in temperature of the battery cell 100.

FIG. 9 is a schematic top plan view of the fuse according to the embodiment of the technology described herein.

FIG. 9 illustrates an area ratio of the fuse. Here, the area ratio of the fuse is based on the area of the fuse 200 in top plan view. The area ratio of the fuse is calculated according to Equation 1:

$$\text{Area ratio} = \text{Area of hole}/\text{area of solder}.$$

Here, the "area of hole" indicates the sum of areas of one or more holes 241 placed on the solder 230. For example, if the cover 240 includes three holes, two of which are placed on the solder 230 and the other one is not placed on the solder 230, the "hole" in the "area of hole" refers to the two holes placed on the solder 230.

For example, the holes 241 may be formed in a rectangular shape, as shown in FIG. 9. Here, each of the holes 241 may have a length b1 at one side and a length b2 at another side. In this case, the area of one hole 241 is calculated by b1xb2. FIG. 9 illustrates an example where the hole 241 includes a first hole 2411 and a second hole 2412, which have the same area and are spaced apart from each other and placed on the solder 230. In this case, the "area of hole" may be calculated by b1xb2x2. However, it should be understood that this is provided only by way of example and the holes 241 may be formed not only in a rectangular shape, but also in a polygonal, circular, elliptical, or irregular shape. Furthermore, the cover 240 may be formed with a single hole 241 or at least three holes 241. The area of hole may be calculated differently depending on the shape and/or the number of holes.

The "area of solder" indicates an area of an upper surface of the solder 230. For example, when the solder 230 includes the second solder 230 as shown in FIG. 6, the area of solder may be the area of the upper surface of the second solder 230.

For example, the upper surface of the solder 230 may have a length a1 at one side and a length a2 at another side. In this case, the area of the solder 230 is calculated by a1xa2. However, it should be understood that this is provided only by way of example and the area of solder may be calculated differently depending on the shape of the solder.

The fuse 200 according to the embodiment of the technology described herein has an area ratio of, for example, 0.4 to 0.65. If the area ratio of the fuse 200 is less than 0.4, it can take a long period of time for vaporization of the solder 230. In this case, the fuse 200 may not provide an open circuit within a suitable period of time. A suitable period of time is, for example, 13.5 seconds, as described with reference to FIG. 7 and FIG. 8. If the area ratio of the fuse exceeds 0.65, the cover 240 can suffer from cracking. Accordingly, the fuse may be formed to have an area ratio of 0.4 to 0.65.

With this structure, the fuse 200 according to the embodiment of the technology described herein can promptly detect and prevent heat propagation from the trigger cell toward the battery cells within the battery module 1000.

Furthermore, the fuse 200 according to the embodiment of the technology described herein can prevent heat propagation from the battery cell 100, which is not provided with a temperature sensor, through the solder 230 and the cover 240, even upon increase in temperature of the battery cell 100.

The fuse 200 according to the embodiment of the technology described herein has been described with reference to FIG. 6 to FIG. 9. Hereinafter, the protection circuit module 300 including such a fuse 200 and a battery module 1000 including the protection circuit module 300 will be described.

FIG. 10 is a top plan view of a battery module according to one embodiment of the technology described herein.

FIG. 11 is an enlarged view of Region A in Fig. 10.

As illustrated in FIG. 5, the battery module 1000 according to the embodiment of the technology described herein includes the plurality of battery cells 100 and the housing 1061 to 1065 that receives the plurality of battery cells 100 therein. The battery module 1000 further includes a protection circuit module 300 at one side of the plurality of battery cells 100. FIG. 10 is a top plan view of the battery module 1000 to which the protection circuit module 300 is applied.

Referring to FIG. 11, the battery cells 100 are electrically connected to the outside through a cap plate 250. The protection circuit module 300 includes a connection plate 260. The connection plate 260 is electrically connected to the cap plate 250. The connection plate 260 may be connected to the cap plate 250 by welding.

In this case, the fuse 200 is placed within a certain distance (Y) from the connection plate 260. If the fuse 200 is placed too far from the connection plate 260, the temperature of the solder 230 may not increase significantly despite increase in temperature of the trigger cell. In this case, the solder 230 may not melt despite heat dissipation from the trigger cell. Here, the position of the fuse 200 is determined relative to the position of the solder 230. The position of the solder 230 is set with reference to a center of the solder 230 or a center of the width of the opening.

In consideration of such a feature, for example, the fuse 200 may be placed at a distance of 40 mm or less from the connection plate 260. Here, a reference position of the connection plate 260 for the distance of 40 mm is a point on the connection plate 260, which is placed at the shortest distance from the fuse 200, for example, on a centerline parallel to the longitudinal direction of the connection plate 260. If the fuse 200 is placed at a distance of greater than 40 mm from the connection plate 260, the temperature of the solder 230 may not increase above the melting point thereof within 13.5 seconds even upon heat propagation from the trigger cell. In this case, the fuse 200 can fail to form an open circuit within 13.5 seconds. For example, the fuse 200 is placed at a distance of 10 mm to 40 mm from the connection plate 260.

With this structure, the fuse 200 according to the embodiment of the technology described herein can promptly detect and prevent heat propagation from the trigger cell toward the cells within the battery module 1000.

Next, comparative examples and examples of the technology described herein will be described with reference to Tables 2 and 3.

Table 2

| Type | X | Circuit | Circuit open time (sec) |
|------|---|---------|-------------------------|
| Example 1 | 1 mm | PASS | 12.20 |
| Example 2 | 2 mm | PASS | 12.30 |
| Example 3 | 3 mm | PASS | 12.70 |
| Example 4 | 4 mm | PASS | 13.10 |
| Comparative Example 1 | 5 mm | NG | 13.50 |
| Comparative Example 2 | 6 mm | NG | 14.20 |
| Comparative Example 3 | 7 mm | NG | 15.50 |

In Table 2, Examples 1 to 4 and Comparative Examples 1 to 3 provide fuses all having the same conditions except for the width x. Specifically, in Examples 1 to 4 and Comparative Examples 1 to 3, the first metal is composed of Cu and the second metal is composed of Pb.

In Table 2, "x" indicates the width of the fuse. "Circuit" indicates the wire 220 of the third cell. "Circuit open time (sec)" indicates a time it takes for the wire 220 of the trigger cell to open.

Examples 1 to 4 provide fuses 200 according to the embodiment of the technology described herein, in which each wire 220 has a width x of 1 mm to 4 mm. As can be seen from Table 2, in Examples 1 to 4, the circuit opens within 13.5 seconds (not including 13.5 seconds). In this case, as described in FIG. 7 and FIG. 8, the fuses 200 can interrupt electrical connection of the trigger cell before the third cell reaches the peak temperature thereof.

Comparative Examples 1 to 3 provide fuses in which each wire 220 has a width x of 5 mm to 7 mm. As can be seen from Table 2, in Comparative Examples 1 to 3, the circuit opens after 13.5 seconds (including 13.5 seconds). In this case, as described in FIG. 7 and FIG. 8, the fuses interrupt electrical connection of the trigger cell after the adjacent cell has reached the peak temperature thereof. That is, the fuses of Comparative Examples 1 to 3 perform late voltage interruption with respect to the trigger cell.

Table 3

| Type | Area ratio | Fusing Time (sec) | Presence of cracks | Fusing Spec |
|---|---|---|---|---|
| Comparative Example 4 | 0.25 | 42.0 | Absent | NG |
| Comparative Example 5 | 0.30 | 31.0 | Absent | NG |
| Comparative Example 6 | 0.35 | 21.0 | Absent | NG |
| Example 5 | 0.40 | 12.0 | Absent | Okay |
| Example 6 | 0.45 | 8.5 | Absent | Okay |
| Example 7 | 0.50 | 8.1 | Absent | Okay |
| Example 8 | 0.55 | 7.5 | Absent | Okay |
| Example 9 | 0.60 | 7.3 | Absent | Okay |
| Example 10 | 0.65 | 7.1 | Absent | Okay |
| Comparative Example 7 | 0.70 | 6.8 | Present | Okay |
| Comparative Example 8 | 0.75 | 6.8 | Present | Okay |

In Table 3, all of Examples 5 to 10 and Comparative Examples 4 to 8 have the same conditions except for the area ratio. Specifically, in Examples 5 to 10 and Comparative Examples 4 to 8, the first metal is composed of Cu and the second metal is composed of Pb.

In Table 3, "area ratio" indicates a value calculated by Equation 1 as described in FIG. 9. In Table 3, "fusing time (sec)" indicates a time it takes for the fuse 200 of the trigger cell to form an open circuit. In Table 3, "presence of cracks" indicates whether or not cracking has occurred in the cover 240. "Fusing Spec" indicates whether the fusing time (sec) falls within 13.5 seconds.

Examples 5 to 10 provide fuses according to embodiments of the technology described herein, in which the area ratio ranges from 0.4 and 0.65. As can be seen from Table 3, in Examples 5 to 10, the fusing time (sec) is within 13.5 seconds. Furthermore, in Examples 5 to 10, cracking does not occur.

Comparative Examples 4 to 6 provide fuses having an area ratio of less than 0.4. As can be seen from Table 3, in Comparative Examples 4 to 6, the fusing time exceeds 13.5 seconds (sec). That is, the fuses of Comparative Examples 4 to 6 interrupt electrical connection of the trigger cell after the adjacent cell has reached the peak temperature thereof. Therefore, the fuses of Comparative Examples 4 to 6 perform late voltage interruption with respect to the trigger cell.

Comparative Examples 7 and 8 provide fuses having an area ratio of greater than 0.65. As can be seen in Table 3, in Comparative Examples 7 and 8, cracking occurs. That is, Comparative Examples 7 and 8 fail to provide the cover 240 and thus do not provide the fuse 200 according to the embodiment of the technology described herein.

**Claims**

1.  A protection circuit module (300) comprising:

    a substrate (210);
    a wire (220) disposed on the substrate (210) to form an opening (221) in at least a portion of the wire (220) and the wire (220) comprising a first metal;
    a solder (230) comprising a second metal having a melting point lower than a melting point of the first metal and the second metal being inserted into at least a portion of the opening (221) to join ends of the wire (220) separated by the opening (221); and
    a cover (240) forming at least one hole (241) and covering at least a portion of the solder (230).

2.  The protection circuit module (300) according to claim 1, wherein the at least one hole (241) is placed on the solder (230) and provides a migration path for vaporized second metal upon vaporization of the second metal.

3.  The protection circuit module (300) according to claim 1 or 2, wherein the opening (221) has a width of 1 mm to 4 mm.

4.  The protection circuit module (300) according to any one of claims 1 to 3, wherein the melting point of the second metal is 200°C or higher.

5. The protection circuit module (300) according to any one of claims 1 to 4, wherein the second metal comprises at least one material selected from the group consisting of Al, Mg, Sb, Zn, Pb, Cd, Bi, and Sn.

6. The protection circuit module (300) according to any one of claims 1 to 5, wherein the cover (240) comprises at least one material selected from the group consisting of polyethylene naphthalate, PEN, polyimide, PI, polyethylene terephthalate, PET, polytetrafluoroethylene, PTFE, polycarbonate, PC, and polyethersulphone, PES.

7. The protection circuit module (300) according to any one of claims 1 to 6, wherein the cover (240) has a thickness of 0.015 mm to 0.060 mm.

8. The protection circuit module (300) according to any one of claims 1 to 7, wherein an area ratio of the at least one hole(241) to the solder (230) ranges from 0.4 to 0.65 in top plan view.

9. The protection circuit module (300) according to any one of claims 1 to 8, further comprising:

   a connection plate (260) electrically connected to a battery cell (100),
   wherein the opening (221) is formed within 40 mm from the connection plate (260).

10. A battery module (1000) comprising:

    a plurality of battery cells (100);
    a housing (1061, 1062, 1063, 1064, 1065) for receiving the plurality of battery cells (100); and
    a protection circuit module (300) disposed at one side of the plurality of battery cells (100), the protection circuit module (300) comprising:

       a substrate (210);
       a wire (220) disposed on the substrate (210) to form an opening (221) in at least a portion of the wire (220) and the wire (220) comprising a first metal;
       a solder (230) comprising a second metal having a melting point lower than a melting point of the first metal and the second metal being inserted into at least a portion of the opening (221) to join ends of the wire (220) separated by the opening (221); and
       a cover (240) forming at least one hole (241) and covering at least a portion of the solder (230).

11. The battery module (1000) according to claim 10, wherein the at least one hole (241) is placed on the solder (230) and provides a migration path for vaporized second metal upon vaporization of the second metal.

12. The battery module (1000) according to claim 10 or 11, wherein the opening (221) has a width of 1 mm to 4 mm.

13. The battery module (1000) according to any one of claims 10 to 12, wherein the melting point of the second metal is 200°C or higher.

14. The battery module (1000) according to any one of claims 10 to 13, wherein an area ratio of the at least one hole(241) to the solder (230) ranges from 0.4 to 0.65 in top plan view.

15. The battery module (1000) according to any one of claims 10 to 14, wherein the protection circuit module (300) further comprises a connection plate (260) electrically connected to the plurality of battery cells and the opening (221) is formed within 40 mm from the connection plate (260).

# FIG. 1

# FIG. 2

# FIG. 3

100

50

72

71

40

10

30

20

# FIG. 4

# FIG. 5

# FIG. 6

# FIG. 7

# FIG. 8

200

# FIG. 9

200

a1
x
b1
a2
b2

220
240
2411 2412
241
221
230
2412

FIG. 10

1000

# FIG. 11

A

Europäisches
Patentamt

European
Patent Office

Office européen
des brevets

# EUROPEAN SEARCH REPORT

**Application Number**

EP 25 16 2224

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 0 517 306 B1 (MICROELECTRONIC MODULES CORP [US]) 9 April 1997 (1997-04-09) * abstract; claims 1-19; figures 1-5 * * column 1, line 3 - line 6 * * column 3, line 1 - line 15 * * column 4, line 34 - line 38 * * column 4, line 52 - column 5, line 1 * * column 3, line 25 - line 36 * * column 4, line 11 - line 28 * * column 5, line 22 - line 25 * - - - - - | 1-15 | INV. H01M10/42 H01M50/581 H01H85/00 H01H85/06 H05K1/00 ADD. H01M50/519 H01H85/02 H01H85/38 |
| Y | JP 2016 134317 A (DEXERIALS CORP) 25 July 2016 (2016-07-25) * abstract; claims 1-12; figures 1,8-10,14 * * paragraphs [0044] - [0046], [0056] - [0060], [0020] - [0021], [0066] * - - - - - | 1-15 | |

**TECHNICAL FIELDS SEARCHED (IPC)**

H01M
H01H
H05K

The present search report has been drawn up for all claims

| Place of search | Date of completion of the search | Examiner |
|---|---|---|
| The Hague | 2 July 2025 | Ramos Alonso, A |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
.................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 16 2224

02-07-2025

| Patent document cited in search report | | Publication date | Patent family member(s) | | Publication date |
|---|---|---|---|---|---|
| EP 0517306 | B1 | 09-04-1997 | DE | 69218828 T2 | 21-08-1997 |
| | | | EP | 0517306 A2 | 09-12-1992 |
| | | | JP | H05198246 A | 06-08-1993 |
| | | | US | 5097247 A | 17-03-1992 |
| JP 2016134317 | A | 25-07-2016 | JP | 2016134317 A | 25-07-2016 |
| | | | TW | 201633352 A | 16-09-2016 |
| | | | WO | 2016117578 A1 | 28-07-2016 |

EPO FORM P0459

For more details about this annex : see Official Journal of the European Patent Office, No. 12/82